# EUROPEAN PATENT SPECIFICATION

(11) **EP 3 704 170 B1**
(45) Date of publication and mention of the grant of the patent: **23.10.2024**
(21) Application number: 18792874.2
(22) Date of filing: 15.10.2018
(51) Int. Cl.: C08F 287/00, C08L 53/00, C08L 53/02, B29C 64/00, G03F 7/00

(54) **CURABLE COMPOSITIONS BASED ON IMMISCIBLE REACTIVE COMPONENTS AND BLOCK COPOLYMER**
HÄRTBARE ZUSAMMENSETZUNGEN AUF DER BASIS VON NICHT MISCHBAREN REAKTIVEN KOMPONENTEN UND BLOCKCOPOLYMER
COMPOSITIONS DURCISSABLES À BASE DE COMPOSANTS RÉACTIFS NON MISCIBLES ET DE COPOLYMÈRE SÉQUENCÉ

(30) Priority: 31.10.2017 US 201762579444 P
(43) Date of publication of application: 09.09.2020
(73) Proprietor: Arkema France, 92700 Colombes (FR)
(72) Inventor: WOLF, William, Philadelphia, PA 19145 (US); LIU, David Shin-Ren, Bala Cynwid, PA 19004 (US); ORILALL, Mahendra Christopher, Downingtown, Pennsylvania 19335 (US)
(74) Representative: Arkema Patent
(86) International application number: PCT/EP2018/078091
(87) International publication number: WO 2019/086234

(56) References cited:
- US-A1- 2007 032 563
- US-A1- 2012 178 845
- LI M ET AL: "Block copolymer patterns and templates", MATERIALS TODAY, ELSEVIER, AMSTERDAM, NL, vol. 9, no. 9, 1 September 2006 (2006-09-01), pages 30 - 39, XP028034381, ISSN: 1369-7021, [retrieved on 20060901], DOI: 10.1016/S1369-7021(06)71620-0

## Description

The present invention relates to curable compositions, methods of making and using such compositions and articles and cured compositions made from such curable compositions.

The polymerization or curing of various functionalized monomers and/or oligomers to provide cured compositions or articles such as adhesives, coatings, sealants, moldings and the like has been studied for many years. For example, (meth)acrylate-functionalized monomers/oligomers may be combined, possibly with other components such as photoinitiators, then subjected to conditions (such as exposure to a radiation source, e.g., ultraviolet light) which are effective to cause the (meth)acrylate functional groups to react with each other and form a polymerized matrix. Typically, such curable compositions are initially liquid (e.g., homogeneous solutions) and are converted to solid form as a result of the curing reaction.

The solid polymeric matrix formed by reaction of the curable monomers and/or oligomers is generally homogeneous, i.e., only a single phase is present. Although the properties and characteristics of such mono-phasic matrices can be controlled and varied to some extent by selecting and combining different types of reactants and using different curing techniques, there are practical limits to what can be achieved due to the fact that the cured product obtained is in the form of a single phase. Accordingly, it would be highly desirable to develop procedures whereby microphase-separated polymeric systems (i.e., cured compositions comprised of two or more polymeric phases or domains which are compositionally different from each other) can be generated starting with the same general types of monomers and oligomers conventionally used to prepare monophasic polymeric systems.

The present inventors have now discovered that block copolymers can be used to structure-direct particular combinations of polymerizable compounds into structures governed by block copolymer phase behavior. In the bulk, block copolymers micro-phase separate on a molecular scale (e.g., 5 to 100 nm) to produce complex, ordered nanostructures with various morphologies, depending upon the volume fraction of one type of block with respect to another type of block and the relative miscibilities of the types of blocks. In contrast, radiation-curable monomeric and oligomeric materials typically do not exhibit any order and therefore polymerize when cured into random networks lacking order. The addition of block copolymers into certain polymerizable compound systems, as embodied in the present invention, has been found to provide an effective mechanism for structure-directing the polymerizable compounds into ordered morphologies when the polymerizable compounds are cured, e.g., by exposure to radiation. This allows for systematic control over structural dimensions, composition and spatial arrangement within the cured composition. Consequently, the present invention permits the preparation of cured compositions having unique properties not capable of being achieved by known technologies.

Without wishing to be bound by theory, it is believed that an ordered system is formed in a liquid phase, before curing of the polymerizable compounds, at least in part due to the presence of the block copolymer. The curing (polymerization) process is thought to kinetically trap the liquid-phase structure.

The cured compositions thereby obtained have short-range ordered structures, as opposed to long-range ordered structures. The term "short-range order(ed)" is understood in the art to describe materials that show order on nanometer length scales, but that are disordered on sub-nanometer scales (i.e., they are not crystalline). See, for example, Li et al., "Block copolymer patterns and templates", Materials Today, September 2006, Vol. 9, No. 9, pp. 30-39.

US 2007/0032563 A1 discloses a composition suitable for supporting and/or building a three-dimensional object, the composition comprising at least one Temperature Sensitive Polymer, and at least one surface-active agent.

US 2012/178845 A1 discloses a radiation curing composition suitable for building a three-dimensional object, the composition comprising monofunctional and difunctional (meth)acrylic monomers having different glass transition temperatures and a silicon oligomer as a phase separation inducing component.

The use of patternable block copolymers for nanostructure fabrication is disclosed in LI M. et al. "Block copolymer patterns and templates", MATERIALS TODAY, ELSEVIER, AMSTERDAM, NL, vol. 9, no. 9, 1 September 2006 (2006-09-01), pages 30-39.

According to one aspect, the present invention provides a curable composition, wherein the curable composition exists in an ordered microphase-separated state at 25°C and is comprised of :
a) a block copolymer comprised of at least a first block and a second block, wherein the first block and the second block have different monomer compositions ;
b) a first reactive component having a higher affinity for the first block of the block copolymer than for the second block of the block copolymer ; and
c) a second reactive component having a higher affinity for the second block of the block copolymer than for the first block of the block copolymer ;
wherein the first reactive component and the second reactive component, in the absence of the block copolymer, are not fully miscible with each other at 25°C.

Generally speaking, the first reactive component and the second reactive component are selected to be sufficiently dissimilar in chemical structure and properties so as to be incompatible with each other on a molecular level, such that when combined together at 25°C in the absence of other substances (such as the block copolymer component of the present invention) they separate into distinct phases visible to the unassisted human eye. One approach to achieving the desired dissimilarity is to have one reactive component be significantly more hydrophilic than the other reactive component. For convenience, the more hydrophilic reactive component may be referred to herein as the "hydrophilic reactive component" and the less hydrophilic reactive component may be referred to herein as the "hydrophobic reactive component". Immiscibility of the reactive components may also be attained by selecting reactive components which are significantly different from each other with respect to their polarity or dipole moment or their ability to form intermolecular associations (through hydrogen bonding, for example). By existing in an ordered microphase-separated state, the curable composition has two or more distinct domains, each having a distinct phase and having a dimension on the order of the microscale range.

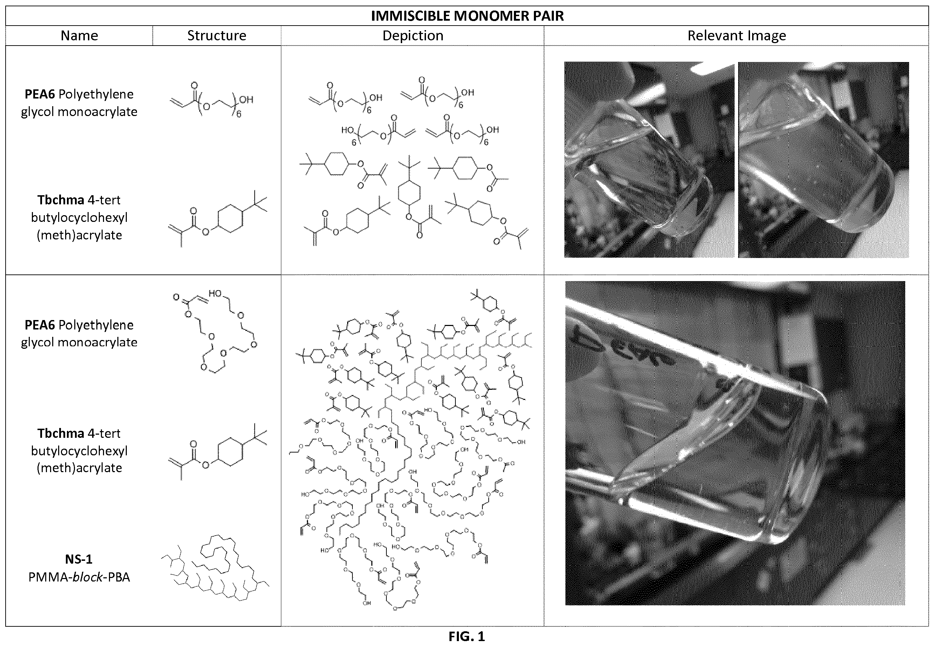

Fig. 1, Fig. 2 and Fig. 3 illustrate in schematic, representative format various aspects of the present invention in which first and second reactive components which normally are not fully miscible with each other are combined with block copolymer to provide curable compositions which exist in an ordered microphase-separated state at 25°C, as well as, for comparative purposes, analogous monomer mixtures not containing block copolymer.

The compounds present in the reactive components may contain one or more functional groups or moieties per molecule capable of reacting (through a polymerization reaction, for example) when the curable composition is cured. In one embodiment, all of the reactive compounds are mono-functional, i.e., they each contain only one such functional group or moiety per molecule. In other embodiments, however, the curable composition comprises both mono-functional reactive compounds and poly-functional reactive compounds (compounds containing two or more reactive functional groups per molecule). Increasing the proportion of poly-functional reactive compounds to mono-functional reactive compounds in the curable composition will generally tend to increase the amount of crosslinking (crosslink density) achieved in the cured composition.

Each reactive component may be comprised of a single reactive compound, wherein the reactive compound present in the first reactive component is different from the reactive compound present in the second reactive component. In other embodiments, one or both of the reactive components may be comprised of two or more reactive compounds which are miscible with each other but immiscible, as a mixture, with the other reactive component.

### Hydrophilic Reactive Component

As previously explained, the curable compositions of the present invention may comprise a hydrophilic reactive component. The hydrophilic reactive component is comprised of one or more hydrophilic reactive compounds, which may be reactive monomers and/or reactive oligomers. For example, the hydrophilic reactive component may be comprised of at least one hydrophilic monomer selected from the group consisting of hydrophilic epoxides, hydrophilic oxetanes, hydrophilic vinyl compounds, hydrophilic (meth)acrylamides and hydrophilic (meth)acrylate-functionalized compounds (which are particularly preferred). As used herein, the term "(meth)acrylate" refers to both acrylate (-O-C(=O)-CH=CH₂) and methacrylate (-O-C(=O)-C(CH₃)=CH₂) functional groups.

As used herein, the term "reactive" means that a compound contains at least one moiety capable of participating in a polymerization or curing reaction whereby a plurality of reactive compound molecules become covalently bonded to each other to form a polymeric structure. Suitable reactive moieties include sites of ethylenic unsaturation (i.e., carbon-carbon double bonds, C=C). Such sites of ethylenic unsaturation can be provided, for example, by (meth)acryloyl, maleyl, allyl, propenyl and/or vinyl groups. As used herein, the term "(meth)acryloyl" is intended to both include methacryloyl and acryloyl.

A reactive compound generally may be rendered hydrophilic by the inclusion of one or more polar functional groups and/or one or more functional groups capable of participating in hydrogen bonding. Such functional groups include, for example, hydroxyl groups, carboxylic acid groups, oxyethylene groups, carboxyl (ester) groups, amide groups, wherein the ratio of such functional groups to the total number of carbon atoms in the reactive compound is relatively high.

According to certain aspects of the invention, the at least one hydrophilic monomer may be selected from the group consisting of acetoxyethyl (meth)acrylate, 2-carboxyethyl (meth)acrylate, phosphate (meth)acrylate monomers (e.g., phosphate esters of hydroalkyl (meth)acrylates), mono-(2-(meth)acryloyloxyethyl) succinate, lactone and lactam (meth)acrylates (such as those obtained by reaction of a hydroxyalkyl(meth)acrylate with one or more (e.g., 1-10) equivalents of caprolactone or caprolactam), (meth)acrylamide, N,N-dimethyl(meth)acrylamide, N-isopropyl(meth)acrylamide, N-vinylformamide, (meth)acryloyl morpholine and diacetone (meth)acrylamide.

For example, the at least one hydrophilic reactive component may comprise at least one half ester which is a reaction product of a hydroxyalkyl (meth)acrylate and a dicarboxylic acid or carboxylic acid anhydride in which only one of the two carboxyl groups of the dicarboxylic acid or carboxylic acid anhydride is esterified. The hydroxyalkyl (meth)acrylate may, for instance, be selected from the group consisting of hydroxyethyl (meth)acrylates and hydroxypropyl (meth)acrylates, as well as alkoxylated hydroxyalkyl (meth)acrylates (e.g., hydroxyalkyl (meth)acrylates that have been reacted with one or more equivalents of an epoxide such as ethylene oxide or propylene oxide). The dicarboxylic acid or carboxylic acid anhydride may, in illustrative embodiments of the invention, be selected from the group consisting of succinic acid, succinic anhydride, malonic acid, methylsuccinic acid and methylsuccinic anhydride. According to a particular aspect of the invention, the at least one hydrophilic reactive component comprises a half ester which is a reaction product of hydroxyethyl acrylate and succinic acid.

Suitable hydrophilic reactive monomers may correspond to formula (I), which may be considered a "half ester" :

HO-C(=O)-R¹-C(=O)-O-R²-O-C(=O)CR³=CH₂ (I)

wherein R³ is H or CH₃ and R¹ and R² are the same or different and are divalent organic moieties each containing one, two or more carbon atoms, wherein R¹ and R² together preferably contain no more than 10 or no more than 8 carbon atoms in total. For example, R¹ may be C₁-C₄ alkylene, e.g., -CH₂-, -CH₂CH₂-, -CH₂CH₂CH₂-, -CH₂CH(CH₃)- or-CH₂CH₂CH₂CH₂- and R² may be C₂-C₄ alkylene, e.g., -CH₂-, -CH₂CH₂-, -CH₂CH₂CH₂-,-CH₂CH(CH₃)- or -CH₂CH₂CH₂CH₂-.

As previously mentioned, ethylenically unsaturated functional groups suitable for use in the present invention include groups containing at least one carbon-carbon double bond, in particular a carbon-carbon double bond capable of participating in a reaction (e.g., a free radical reaction) wherein at least one carbon of the carbon-carbon double bond becomes covalently bonded to an atom, in particular a carbon atom, in a second molecule. Such reactions may result in a polymerization or curing whereby the compound(s) containing one or more ethylenically unsaturated functional groups become(s) part of a polymerized matrix or polymeric chain. The carbon-carbon double bond may, for example, be present as part of an α,β-unsaturated carbonyl moiety, e.g., an α,β-unsaturated ester moiety such as an acrylate functional group (H₂C=CH-C(=O)O-) or a methacrylate functional group (H₂C=C(CH₃)-C(=O)O-). A carbon-carbon double bond may also be present in the ethylenically unsaturated functional group in the form of a vinyl group-CH=CH₂ or an allyl group, -CH₂-CH=CH₂.

Additional examples of suitable hydrophilic (meth)acrylate-functionalized compounds include, but are not limited to, hydroxyethyl (meth)acrylate, hydroxypropyl (meth)acrylate, alkoxylated (e.g., ethoxylated) hydroxyethyl (meth)acrylates and alkoxylated (e.g., ethoxylated) hydroxypropyl (meth)acrylates, N-(meth)acryloylmorpholine, 2-(2-ethoxyethoxy)ethyl (meth)acrylate, triethylene glycol monomethyl ether mono(meth)acrylate, polyethoxy ethyl (meth)acrylate, (meth)acrylic acid, maleic acid, half esters of maleic anhydride, trimethylolpropane mono(meth)acrylate, pentaerythritol mono(meth)acrylate, dipentaerythritol mono(meth)acrylate, glycerol mono(meth)acrylate, neopentyl glycol mono(meth)acrylate, urethane (meth)acrylates (both monomeric and oligomeric, including mono(meth)acrylate-functionalized urethane (meth)acrylates such as the reaction products of hydroxyalkyl (meth)acrylates with isocyanate, e.g., butyl isocyanate), and epoxy (meth)acrylates (e.g., reaction products of (meth)acrylic acid and an epoxide such as glycidol, glycidyl-terminated polyethylene oxide, glycidyl ethers of phenols (e.g., cresol) and bisphenols (e.g., bisphenol A), glycidyl ethers of C₂-C₈ aliphatic alcohols (including monoalcohols and polyols, such as butanediol and trimethylolpropane).

In one embodiment, the hydrophilic (meth)acrylate-functionalized compound is a polyethylene glycol monoacrylate or a mixture of polyethylene glycol monoacrylates. Such polyethylene glycol monoacrylates may correspond to the structural formula H₂C=CHC(=O)(OCH₂CH₂)ₙOH, wherein n is an integer of from 2 to 30 (e.g., 4 to 12).

Examples of suitable hydrophilic epoxides include, but are not limited to, glycidyl ethers such as 2-hydroxyethyl glycidyl ether, hydroxypropyl glycidyl ether, alkoxylated (e.g., ethoxylated) hydroxyethyl glycidyl ethers, alkoxylated (e.g., ethoxylated) hydroxypropyl glycidyl ethers, glycidyl ethers of polyalkylene glycols such as polyethylene glycols and polypropylene glycols, glycidyl ethers of polyalkylene glycol monoethers such as polyethylene glycol monomethyl ether, 2-(2-ethoxyethoxy)ethyl glycidyl ether, triethylene glycol monomethyl ether monoglycidyl ether, polyethoxy ethyl glycidyl ether, glycidyl ethers of trimethylolpropane and trimethylolethane such as trimethylolpropane monoglycidyl ether, glycidyl ethers of pentaerythritol such as pentaerythritol monoglycidyl ether, glycidyl ethers of dipentaerythritol such as dipentaerythritol monoglycidyl ether, glycidyl ethers of glycerol such as glycerol monoglycidyl ether, glycidyl ethers of neopentyl glycol such as neopentyl glycol monoglycidyl ether, glycidyl ethers of sugars and sugar alcohols, urethane glycidyl ethers (both monomeric and oligomeric) and glycidyl (meth)acrylate.

Examples of suitable hydrophilic oxetanes include, but are not limited to, oxetanyl methanol ethers such as 2-hydroxyethyl oxetanyl methanol ether, hydroxypropyl oxetanyl methanol ether, alkoxylated (e.g., ethoxylated) hydroxyethyl oxetanyl methanol ethers and alkoxylated (e.g., ethoxylated) hydroxypropyl oxetanyl methanol ethers, 2-(2-ethoxyethoxy)ethyl oxetanyl methanol ether, triethylene glycol monomethyl ether monooxetanyl methanol ether, polyethoxy ethyl oxetanyl methanol ether, trimethylolpropane monooxetanyl methanol ether, pentaerythritol monooxetanyl methanol ether, dipentaerythritol monooxetanyl methanol ether, glycerol monooxetanyl methanol ether, neopentyl glycol monooxetanyl methanol ether, and urethane oxetanyl methanol ethers (both monomeric and oligomeric) as well as hydroxyl- and carboxylic acid-functionalized oxetanes such as 3-hydroxy oxetane, oxetane-3-carboxylic acid, oxetane-3-methanol, 3-ethyl-3-hydroxymethyl oxetane and 3-hydroxymethyl-3-methyl oxetane.

Examples of suitable hydrophilic vinyl compounds include, but are not limited to, allyl alcohol, ethylene glycol vinyl ether (2-hydroxyethyl vinyl ether), alkoxylated (e.g., ethoxylated) allyl alcohols, trimethylolpropane mono allyl ether, hydroxypolyethoxy allyl ether, N-vinyl-N-methyl acetamide, vinylphosphonic acid, diethylvinylphosphonic acid, phenylvinylphosphonic acid, dimethylvinylphosphonic acid, di-n-butylvinylphosphonic acid, di-isobutylvinylphosphonic acid, di-isopropylvinylphosphonic acid, 2-aminoethyl vinyl ether, methyl vinyl ether, 2-acetoxyethyl vinyl ether, vinyl pyrrolidones, vinyl caprolactams.

Examples of suitable hydrophilic (meth)acrylamides include, but are not limited to, N-iso-propylacrylamide, N-(2-hydroxypropyl) (meth)acrylamide, (meth)acrylamide, N,N-dimethyl(meth)acrylamide and diacetone (meth)acrylamide.

Examples of suitable phosphate ester (meth)acrylate monomers include, but are not limited to, compounds corresponding to the following formula (II) :

H₂C=CR¹C(=O)-(-O-(-CR²R³-)ₘ)ₙ-OP(=O)(OH)₂ (II)

wherein R¹ is hydrogen or a methyl group, R² and R³ independently represent hydrogen or an alkyl group having 1 to 8 carbon atoms and m and n independently represent an integer of 1 to 20. Specific examples of suitable phosphate ester (meth)acrylate monomers include 2-(meth)acryloxyethyl phosphate, 3-(meth)acryloxypropyl phosphate, 2-(meth)acryloxypropyl phosphate, 4-(meth)acryloxybutyl acrylate, diethylene glycol (meth)acrylate phosphate, triethylene glycol (meth)acrylate phosphate and polyethylene glycol (meth)acrylate phosphate.

### Hydrophobic Reactive Component

As previously mentioned, the hydrophobic reactive component is selected to be a reactive compound or mixture of reactive compounds that is not fully miscible with the hydrophilic reactive component at 25°C, in the absence of the block copolymer (i.e., the hydrophobic reactive component visibly phase separates from the hydrophilic reactive component, when the components are combined). Typically, the hydrophobic reactive component is less polar than the hydrophilic reactive component, although it may contain one or more polar functional groups such as an ester group. Generally speaking, the hydrophobicity of a reactive compound may be increased, for example, by the inclusion of long chain alkyl groups, C5+ cycloaliphatic rings and/or aromatic rings and/or by increasing the ratio of total carbon atoms to polar and/or active hydrogen-containing functional groups (such as hydroxyl groups, carboxylic acid groups, oxyethylene groups, carboxyl (ester) groups).

According to certain aspects of the invention, the at least one hydrophobic reactive component may comprise at least one (meth)acrylate ester of a C₄-C₂₄ aliphatic mono-alcohol (i.e., a C₄-C₂₄ aliphatic mono-alcohol esterified with acrylic acid or methacrylic acid). The aliphatic mono-alcohol may be linear or branched in structure. The aliphatic mono-alcohol may be comprised of one or more cycloaliphatic rings. The cycloalkyl group may be a monocyclic alkyl group, such as a cyclopentyl, cyclohexyl or cycloheptyl group or a polycyclic alkyl group (substituted or unsubstituted), such as an isobornyl group or tricyclodecyl group. Suitable polycyclic alkyl groups include polycyclic alkyl groups having a fused ring system, polycyclic alkyl groups having a bridged ring system, as well as polycyclic alkyl groups having both a fused ring system and a bridged ring system.

The hydroxyl group of the aliphatic mono-alcohol may be directly substituted on a cycloaliphatic ring or may be substituted on a non-cycloaliphatic organic moiety (e.g., -CH₂-) which is bonded to a cycloaliphatic ring. The hydroxyl group of the aliphatic mono-alcohol may be a primary, secondary or tertiary hydroxyl group. In one embodiment of the invention, the aliphatic mono-alcohol is saturated.

Examples of suitable aliphatic mono-alcohols include, but are not limited to, n-butanol, sec-butyl alcohol, n-pentanol, n-hexanol, n-heptanol, n-octanol, 3-methyl-3-pentanol, pelargonic alcohol, 1-decanol, fatty alcohols (e.g., lauryl alcohol, stearyl alcohol, undecyl alcohol, tridecyl alcohol, myristyl alcohol, pentadecyl alcohol, cetyl alcohol, nonadecyl alcohol, 1-eicosanol, 1-heneicosanol), cyclohexanol, 4-tert-butyl-cyclohexanol, cyclohexane ethanol, cyclohexane methanol, 4-methylcyclohexane methanol, menthol, 2-ethoxyethanol, isobornyl alcohol, 2-methyl-2-butanol, 3-methylbutanol, 2-methyl-1-propanol.

According to other aspects of the invention, the at least one hydrophobic reactive component comprises a C₄-C₂₄ alkyl acrylate.

Aromatic (meth)acrylates, including alkylated aromatic (meth)acrylates and aralkyl (meth)acrylates, are also suitable for use in or as the hydrophobic reactive component.

Cycloaliphatic (meth)acrylates represent another type of (meth)acrylate-functionalized compound useful as a hydrophobic reactive monomer in the present invention. As used herein, the term "cycloaliphatic (meth)acrylate" means compounds containing at least one cycloaliphatic moiety per molecule as well as an acrylate or methacrylate functional group, which may be attached directly or indirectly (e.g., through an alkylene group, such as -CH₂- or -CH₂CH₂-) to the cycloaliphatic moiety. The cycloaliphatic moiety may be cyclopentyl, cyclohexyl, cyclooheptane, cyclooctyl may be monocyclic or polycyclic and/or may be substituted with one or more other groups, such as a straight chain or branched alkyl group.

Illustrative examples of compounds suitable for use in the hydrophobic reactive component are n-butyl (meth)acrylate, sec-butyl (meth)acrylate, t-butyl (meth)acrylate, n-pentyl (meth)acrylate, n-hexyl (meth)acrylate, n-heptyl (meth)acrylate, n-octyl (meth)acrylate, iso-octyl (meth)acrylate, 3-methyl-3-pentyl (meth)acrylate, 2-ethylhexyl (meth)acrylate, t-amyl (meth)acrylamide, pelargonyl (meth)acrylate, 1-decyl (meth)acrylate, isodecyl (meth)acrylate, fatty (meth)acrylates (e.g., lauryl (meth)acrylate, stearyl (meth)acrylates, undecyl (meth)acrylate, tridecyl (meth)acrylate, myristyl (meth)acrylate, pentadecyl (meth)acrylate, cetyl (meth)acrylate, hexadecyl (meth)acrylate, nonadecyl (meth)acrylate, 1-eicosanyl (meth)acrylate, 1-heneicosanyl (meth)acrylate, behenyl (meth)acrylate), cyclohexyl (meth)acrylate, cyclohexane ethyl (meth)acrylate, cyclohexane methyl (meth)acrylate, 4-methylcyclohexane methyl (meth)acrylate, menthyl (meth)acrylate, isobornyl (meth)acrylate, 2-methyl-2-butanol, 3-methylbutyl (meth)acrylate, 2-methyl-1-propyl (meth)acrylate, phenyl (meth)acrylate, 2-naphthyl (meth)acrylate, benzyl (meth)acrylate, alkylphenyl (meth)acrylates, 4-tert-butyl-cyclohexyl (meth)acrylate and combinations thereof.

The hydrophobic reactive component may include or be a vinyl aromatic compound, particularly a vinyl aromatic compound that does not have any polar substituents on the aromatic ring. The aromatic ring (e.g., a phenyl ring or naphthenyl ring) may be substituted with one or more alkyl groups. Examples of suitable hydrophobic vinyl aromatic compounds include styrene, alpha-methyl styrene, vinyl naphthalene, 3-methylstyrene, 4-methylstyrene, 2,4-dimethylstyrene, 2,5-dimethylstyrene, 3,5-dimethylstyrene, 2,4,6-trimethylstyrene and 4-tert-butylstyrene, divinyl benzene, vinyl toluene.

Vinyl cycloaliphatic compounds (e.g., vinyl cyclohexane) and long chain olefins (e.g., C₆-C₂₄ olefins such as 1-decene) may be used as or in the hydrophobic reactive component.

Hydrophobic (meth)acrylamides may also be utilized in the present invention, particularly (meth)acrylamides containing relatively long chain alkyl groups substituted on the nitrogen atom, such as a C₆-C₂₄ alkyl group (which may be straight chain or branched, for example). Hydrophobic (meth)acrylamides suitable for use in the present invention include N-(n-decyl)(meth)acrylamide, N-(n-octadecyl)(meth)acrylamide, N-(n-dodecyl)(meth)acrylamide, N-tert-octyl(meth)acrylamide.

### Amounts of First and Second Reactive Components

The relative amounts of the first (e.g., hydrophilic) reactive component and second (e.g., hydrophobic) reactive component in the curable composition may be readily varied and controlled as may be desired in order to achieve particular ordered structures in the cured composition or article obtained by curing the curable composition. The curable composition may, for example, be comprised of from 10 to 90% by weight first (e.g., hydrophilic) reactive component and from 90 to 10% by weight second (e.g., hydrophobic) reactive component based on the total weight of first (e.g., hydrophilic) reactive component and second (e.g., hydrophobic) reactive component.

Varying the relative proportions of the first and second reactive components may influence the type of phase structure obtained in the composition once it is cured. For example, the morphology of one phase in the cured composition may be characterized as dispersed spheres, cylinders, gyroidal or lamellae, depending upon the ratio of first reactive component to second reactive component.

### Block Copolymer

The curable compositions of the present invention comprise at least one block copolymer. Without wishing to be bound by theory, it is believed that the block copolymer assists in the formation of an ordered nanostructured polymeric matrix upon curing of the immiscible first and second reactive components. The first reactive component may preferentially associate with ("solvate") one type of block present in the block copolymer, whereas the second reactive component may preferentially associate with ("solvate") another type of block present in the block copolymer. As a result, the concentration of the first reactive component in the region proximate to a first block of the block copolymer may be higher than the concentration of the second reactive component in that same region. Likewise, the concentration of the second reactive component in the region proximate to a second block of the block copolymer (having a different monomer composition than that of the first block) may be higher than the concentration of the first reactive component in that same region. Accordingly, the block copolymer may assist in pre-assembling the reactive components into domains in a liquid phase associated with their respective affinity to (i.e., tendency to associate with) each type of block. As an example, where the first reactive component is more hydrophilic than the second reactive component and the block copolymer contains a first block that is more hydrophilic than a second block, the first reactive component will tend to affiliate more strongly with the first block whereas the second reactive component will tend to affiliate more strongly with the second block. The block copolymer thus may be considered to be functioning in a manner similar to that of a surfactant or soap, having a hydrophilic end that associates strongly with a water phase and a hydrophobic end that associates strongly with an oil phase.

In certain embodiments, the curable composition is comprised of at least one of a diblock copolymer or a triblock copolymer. The structure of the block copolymer may be selected such that the block copolymer comprises two different types of blocks, wherein one type of block has a higher affinity for a first reactive component (e.g., a hydrophilic reactive component) than for a second reactive component (e.g., a hydrophobic reactive component) and the other type of block has a higher affinity for the second reactive component than for the first reactive component. Thus, when the first reactive component, second reactive component and block copolymer are combined to form a mixture, the first reactive component may associate to a greater degree with one type of block in the block copolymer whereas the second reactive component may associate to a greater degree with another type of block in the block copolymer. Each type of block present in the block copolymer may have a glass transition temperature which differs from the glass transition temperature(s) of the other type(s) of block(s). The at least one block copolymer may, for example, comprise at least one block having a glass transition temperature of at least 25°C and at least one block having a glass transition temperature of less than 25°C. In other embodiments, the at least one block copolymer may comprise at least one block having a glass transition temperature of at least 50°C and at least one block having a glass transition temperature of less than -25°C. By "Tg" is meant the glass transition temperature of a polymer, measured by Differential Scanning Calorimetry (DSC) in accordance with the standard ASTM E1356.

According to various preferred embodiments, the at least one block copolymer comprises at least one block copolymer selected from the group consisting of a) block copolymers comprised of at least one poly(n-butyl acrylate) block and at least one poly(methyl methacrylate) block, b) block copolymers comprised of at least one polystyrene block and at least one polybutadiene block and c) block copolymers comprised of at least one polystyrene block and at least one polyisoprene block.

The overall molecular weight of the block copolymer is not believed to be particularly critical. For example, the at least one block copolymer may have a number average molecular weight of from 3,000 to 200,000 Daltons (as measured by gel permeation chromatography (GPC)) using polystyrene references. The polydispersity of the block copolymer may, for example, be from 1 to 2, from 1 to 1.5 or from 1 to 1.3.

According to one aspect of the invention, the curable composition comprises at least one thermoplastic acrylic block copolymer. For example, the curable composition may be comprised of at least one thermoplastic acrylic block copolymer having a general formula (A)ₙB in which n is an integer of greater than or equal to 1, A is an acrylic or methacrylic homo- or copolymer having a Tg of greater than 50°C, preferably of greater than 80°C or polystyrene or an acrylic/styrene or methacrylic/styrene copolymer. Preferably, A is methyl methacrylate, phenyl methacrylate, benzyl methacrylate or isobornyl methacrylate. Preferably, the block A is PMMA or PMMA modified with acrylic or methacrylic comonomers, B is an acrylic or methacrylic homo- or copolymer having a Tg of less than 20°C, preferably consisting of (in polymerized form) methyl acrylate, ethyl acrylate, butyl acrylate, ethylhexyl acrylate or butyl methacrylate, more preferably butyl acrylate.

Furthermore, the blocks A and/or B can comprise other acrylic or methacrylic comonomers carrying various functional groups known to a person skilled in the art, for example acid, amide, amine, hydroxyl, epoxy or alkoxy functional groups. The A block(s) can incorporate monomers, such as acrylic acid or methacrylic acid, in order to increase the temperature stability thereof.

According to various preferred aspects, the block copolymer may have a structure chosen from : ABA, AB, A₃B₂ and A₄B₃ (wherein A₃B₂ and A₄B₃ may have linear, radial or branched-type structures).

Preferably, the thermoplastic acrylic block copolymer may be selected from the following triblock copolymers : pMMA-pBuA-pMMA, p(MMAcoMAA)-pBuA-p(MMAcoMAA) and p(MMAcoAA)-pBuA-p(MMAcoAA), wherein MMA = methyl methacrylate, BuA = butyl acrylate, MAA = methacrylic acid, AA = acrylic acid. In one embodiment, the block copolymer is of MAM type (PMMA-pBuA-PMMA).

In certain aspects of the invention, the block copolymer comprises at least one relatively hydrophilic block (such as a polyethylene oxide block, a polyhydroxyethyl(meth)acrylate block, a poly(N,N-dimethylacrylamide) block or a block prepared from one or more of the hydrophilic monomers mentioned previously in connection with the reactive components) and at least one block that is less hydrophilic (such as a polystyrene block, a polycyclohexane block or a block prepared from one or more of the hydrophobic monomers mentioned previously in connection with the reactive components).

The components of the curable composition may, in various embodiments of the invention, be selected so that the curable composition is comprised of at least a first block and a second block, a first reactive component comprised of at least one monomer corresponding to at least one monomer present in polymerized form in the first block and a second reactive component comprised of at least one monomer present in polymerized form in the second block, wherein the first block and the second block have different monomer compositions. In further embodiments, the curable composition is comprised of at least a first block and a second block, a first reactive component comprised of at least one monomer corresponding to at least one monomer present in polymerized form in the first block and a second reactive component comprised of at least one monomer which is different from the at least one monomer present in polymerized form in the first block.

According to certain embodiments, the block(s) B may represent from 25% to 75% of the total weight of the block copolymer, e.g., from 40% to 65% (with, in certain embodiments, the block(s) A representing the balance of the total weight of the block copolymer). Each block B may have, for example, a number average molecular weight of between 5,000 g/mol and 200,000 g/mol, e.g., from 10,000 g/mol to 50,000 g/mol. The number average molecular weight of each block A may fall within such ranges as well; the number average molecular weights of the block(s) A and the block(s) B may be similar to or different from, each other.

In one aspect of the invention, the curable composition comprises a PMMA-pBuA-PMMA block copolymer wherein the number average molecular weight of each PMMA block is from 5000 to 10,000 g/mol and the number average molecular weight of the pBuA block is from 10,000 to 20,000 g/mol.

Other types of suitable block copolymers include, but are not limited to, polyethylene oxide/polypropylene oxide/polyethylene oxide (PEO/PPO/PEO) block copolymers, polyethylene oxide/polypropylene oxide (PEO/PPO) block copolymers, polypropylene oxide/polyethylene oxide/polypropylene oxide (PPO/PEO/PPO) block copolymers, polystyrene/polyethylenebutylene/polystyrene (PS/PEB/PS) block copolymers, polystyrene/polybutadiene/polystyrene (PS/PB/PS) block copolymers, polystyrene/polyethylene oxide (PS/PEO) block copolymers, polyethylene/polyethylene oxide block copolymers, polydimethylacrylamide/polybutylacrylate/polydimethylacrylamide block copolymers, segmented polyurethanes (having a plurality of relatively hydrophilic segments, such as polyether segments and a plurality of relatively hydrophobic segments, such as urethane segments), poly(dimethylsiloxane/polycaprolactone/polydimethylsiloxane block copolymers, polyamide/polyether block copolymers, polyether/polyester block copolymers, polylactic acid/polyethylene oxide block copolymers, poly(lactide-co-glycolide)/polyethylene oxide block copolymers, polycaprolactone/polyethylene oxide block copolymers, polyethylene oxide/silicone block copolymers.

Block copolymers suitable for use in the present invention may be readily prepared using conventional methods known in the art (e.g., controlled radical polymerization (CRP) or by anionic polymerization) or obtained from commercial sources, such as the block copolymers sold under the brand name "Nanostrength" by The Arkema Group.

In various embodiments of the invention, the curable composition comprises an amount of block copolymer effective to provide a homogeneous, stable curable composition. For example, the amount of block copolymer may be sufficient to provide a curable composition which exhibits no bulk phase separation of the first (e.g., hydrophilic) reactive component and the second (e.g., hydrophobic) reactive component after 7 days at 25°C. According to certain aspects, the curable composition may be comprised of from 1 to 40% or from 2 to 20% by weight block copolymer based on the total weight of the curable composition.

The curable composition may consist of first (e.g., hydrophilic) reactive component, second (e.g., hydrophobic) reactive component, and block copolymer, with no other type of component being present. However, in other embodiments the curable composition may additionally comprise one or more additional components, such as those mentioned below. According to certain embodiments, the curable composition may comprise 0 to 50, 0 to 25, 0 to 10, 0 to 5 or 0 to 1% by weight, based on the total weight of the curable composition, of components other than the first (e.g., hydrophilic) reactive component, second (e.g., hydrophobic) reactive component and block copolymer.

### Photoinitiator

If the curable composition is to be cured using light, such as ultraviolet light, it will generally be desirable to formulate the composition to include one or more photoinitiators. However, if electron beam or chemical curing is employed, then the curable composition need not contain any photoinitiator.

A photoinitiator is a compound that undergoes a photoreaction on absorption of light, producing reactive species. The reactive species which are generated then initiate polymerization of the reactive components of the curable composition, e.g., the first (e.g., hydrophilic) reactive component and the second (e.g., hydrophobic) reactive component. Generally speaking, when the compounds present in the reactive components contain carbon-carbon double bonds, such polymerization (curing) involves reaction of such carbon-carbon double bonds. The reactive species may be, for example, a free radical species or an anionic species, in various embodiments of the invention. Suitable photoinitiators include, for example, alpha-hydroxy ketones, phenylglyoxylates, benzyldimethylketals, alpha-aminoketones, mono-acyl phosphines, bis-acyl phosphines, metallocenes, phosphine oxides, benzoin ethers and benzophenones and combinations thereof.

Specific examples of suitable photoinitiators include, but are not limited to, 2-methylanthraquinone, 2-ethylanthraquinone, 2-chloroanthraquinone, 2 benzyanthraquinone, 2-t-butylanthraquinone, 1,2-benzo-9,10-anthraquinone, benzyl, benzoin, benzoin methyl ether, benzoin ethyl ether, benzoin isopropyl ether, alpha-methylbenzoin, alpha-phenylbenzoin, Michler's ketone, benzophenone, 4,4'-bis-(diethylamino) benzophenone, acetophenone, 2,2 diethyloxyacetophenone, diethyloxyacetophenone, 2-isopropylthioxanthone, thioxanthone, diethyl thioxanthone, acetylnaphthalenes, ethyl-p-dimethylaminobenzoate, benzil ketone, α-hydroxy keto, 2,4,6-trimethylbenzoyldiphenyl phosphinoxide, benzyl dimethyl ketal, benzil ketal (2,2-dimethoxy-1,2-diphenylethanone), 1-hydroxycylclohexyl phenyl ketone, 2-methyl-1-[4-(methylthio) phenyl]-2-morpholinopropanone-1, 2-hydroxy-2-methyl-1-phenyl-propanone, oligomeric α-hydroxy ketone, phenylbis(2,4,6-trimethylbenzoyl)phosphine oxide, ethyl-4-dimethylamino benzoate, ethyl(2,4,6-trimethylbenzoyl)phenyl phosphinate, anisoin, anthraquinone, anthraquinone-2-sulfonic acid, sodium salt monohydrate, (benzene) tricarbonylchromium, benzil, benzoin isobutyl ether, benzophenone/1-hydroxycyclohexyl phenyl ketone, 50/50 blend, 3,3',4,4'-benzophenonetetracarboxylic dianhydride, 4-benzoylbiphenyl, 2-benzyl-2-(dimethylamino)-4'-morpholinobutyrophenone, 4,4'-bis(diethylamino)benzophenone, 4,4'-bis(dimethylamino)benzophenone, camphorquinone, 2-chlorothioxanthen-9-one, dibenzosuberenone, 4,4'-dihydroxybenzophenone, 2,2-dimethoxy-2-phenylacetophenone, 4-(dimethylamino)benzophenone, 4,4'-dimethylbenzil, 2,5-dimethylbenzophenone, 3,4-dimethylbenzophenone, diphenyl(2,4,6-trimethylbenzoyl)phosphine oxide /2-hydroxy-2-methylpropiophenone, 50/50 blend, 4'-ethoxyacetophenone, 2,4,6-trimethylbenzoyldiphenylphophine oxide, phenyl bis(2,4,6-trimethyl benzoyl)phosphine oxide, ferrocene, 3'-hydroxyacetophenone, 4'-hydroxyacetophenone, 3-hydroxybenzophenone, 4-hydroxybenzophenone, 1-hydroxycyclohexyl phenyl ketone, 2-hydroxy-2-methylpropiophenone, 2-methylbenzophenone, 3-methylbenzophenone, methybenzoylformate, 2-methyl-4'-(methylthio)-2-morpholinopropiophenone, phenanthrenequinone, 4'-phenoxyacetophenone, (cumene)cyclopentadienyl iron(ii) hexafluorophosphate, 9,10-diethoxy and 9,10-dibutoxyanthracene, 2-ethyl-9,10-dimethoxyanthracene, thioxanthen-9-one and combinations thereof.

Exemplary combinations of suitable photoinitiators include blends of 2-hydroxy-2-methyl-1-phenyl-1-propanone, 2,4,6-trimethylbenzoylphenylphosphinic acid ethyl ester and phenylbis(2,4,6-trimethylbenzoyl) phosphine oxide and blends of 2-hydroxy-2-methyl-1-phenyl-1-propanone and diphenyl (2,4,6-trimethylbenzoyl) phosphine oxide.

Also useful in the present invention are organometallic titanocene photoinitiators such as Irgacure^{®} 784 bis(.eta.5-2,4-cyclopentadien-1-yl)-bis(2,6-difluoro-3-(1H-pyrrol-1-yl)-phenyl) titanium.

If photoinitiator is employed in the curable composition, it may generally be present in a total concentration of up to about 15% by weight based on the total weight of the curable composition (e.g., a concentration of from about 0.1 to about 5% by weight based on the total weight of the curable composition).

### Inorganic Nanoparticles

The curable composition of the present invention may additionally comprise one or more types of inorganic nanoparticles, which may or may not contain organic constituents (e.g., organically-modified inorganic nanoparticles). Such inorganic nanoparticles may be dispersed in one or both of the first (e.g., hydrophilic) reactive component or the second (e.g., hydrophobic) reactive component. Suitable types of inorganic nanoparticles include, for example, silica nanoparticles, alumina nanoparticles, iron oxide nanoparticles, niobia nanoparticles, titania nanoparticles, mixed oxide nanoparticles (e.g., silica/alumina nanoparticles), metal nanoparticles, intermetallic nanoparticles, zirconia nanoparticles, clay nanoparticles (including organically modified and/or intercalated clay nanoparticles), graphene and combinations thereof. By including inorganic nanoparticles in the curable composition, it is possible to produce ordered hybrid inorganic-polymer composites by curing such inorganic nanoparticle-containing curable compositions.

Candidate inorganic nanoparticles, the chemical nature of which is described above, can also be defined by their physical size in as measured in one of more dimensions depending on the general geometric shape of the particle in question. Typical three-dimensional spherical-like particles such as silicas, for example can be defined by measurement of a particle diameter from one edge, perpendicularly through the center of the particle, to the opposite edge of the particle. In the case of a faceted, dendritic or otherwise geometrically-shaped particle, the diameter can be defined as the measurement from one facet face or apex, perpendicularly through the center of the particle to the opposite face or apex. In the case where multiple nanoparticles may be agglomerated into larger structures, descriptions in this invention relate to the smallest three-dimensional sub-unit of such agglomerates. For application in this invention, three-dimensional nanoparticles will have a diameter as defined previously ranging from 0.5 nm to 1000 nm, preferably from 1.0 to 200 nm and most preferably from 1.0 to 100 nm.

In the case of sheet-like two-dimensional nanoparticles, where an individual particle can be defined as having a thickness of likely less than 1 nm, its length and width dimensions could be relatively large, ranging from 1.0 nm to 100 µm, preferably from 5.0 nm to 10 µm and most preferably from 10.0 nm to 5 µm. These types of materials typically exist as stacks of multiple "sheets" which can be separated into individual "sheets" or particles by various physical processing or chemical methodologies as known in the art.

If inorganic nanoparticles are employed in the curable composition, they may generally be present in a total concentration of up to about 50% by weight based on the total weight of the curable composition (e.g., a concentration of from about 0.1 to about 25% by weight based on the total weight of the curable composition).

### Other Components of the Curable Compositions

The curable compositions of the present invention may optionally contain one or more additives instead of or in addition to the above-mentioned components. Such additives include, but are not limited to, antioxidants, ultraviolet absorbers, photo stabilizers, foam inhibitors, flow or leveling agents, colorants, pigments, dispersants (wetting agents), slip additives, fillers (other than or in addition to inorganic nanoparticles), thixotropic agents, matting agents, accelerators, adhesion promoters (such as acidic adhesion promoters), thermoplastics and other types of polymers (other than or in addition to the above-described block copolymers), waxes or other various additives, including any of the additives conventionally utilized in the coating, sealant, adhesive, molding or ink arts.

### Methods of Use

The curable compositions of the present invention are useful as inks (in graphic arts applications, including for food packaging), molding resins, 3D printing resins, coatings (e.g., fiber optic coatings and "soft touch" coatings), sealants and adhesives (e.g., UV-curable laminating adhesives, UV-curable hotmelt adhesives), among other potential applications.

Cured compositions prepared from curable compositions as described herein may be used, for example, in three-dimensional articles (wherein the three-dimensional article may consist essentially of or consist of the cured composition), coated articles (wherein a substrate is coated with one or more layers of the cured composition), laminated or adhered articles (wherein a first component of the article is laminated or adhered to a second component by means of the cured composition) or printed articles (wherein graphics or the like are imprinted on a substrate, such as a paper, plastic or metal substrate, using the cured composition).

The curable compositions may be subjected to curing by means of free radical polymerization or other types of polymerization (e.g., anionic or cationic polymerization).

Curing of the curable compositions in accordance with the present invention may be carried out by any suitable method, such as free radical, cationic and/or anionic polymerization. One or more initiators, such as a free radical initiator (e.g., photoinitiator, peroxide initiator) may be present in the curable composition. Prior to curing, the curable composition may be applied to a substrate surface in any known conventional manner, for example, by spraying, knife coating, roller coating, casting, drum coating, dipping and the like and combinations thereof. Indirect application using a transfer process may also be used. A substrate may be any commercially relevant substrate, such as a high surface energy substrate or a low surface energy substrate, such as a metal substrate or plastic substrate, respectively. The substrates may comprise metal, paper, cardboard, glass, thermoplastics such as polyolefins, polycarbonate, acrylonitrile butadiene styrene (ABS) and blends thereof, composites, wood, leather and combinations thereof. When used as an adhesive, the composition may be placed between two substrates and then cured, the cured composition thereby bonding the substrates together.

Curing may be accelerated or facilitated by supplying energy to the composition, such as by heating the composition and/or by exposing the composition to a radiation source, such as visible or UV light, infrared radiation and/or electron beam radiation. Thus, the cured composition may be deemed the reaction product of the curable composition, formed by curing.

The curable compositions of the present invention are particularly well suited to being cured using LED (Light Emitting Diode) curing (e.g., UV LED curing, using radiation from a UV LED device) and for use in high speed applications (such as coatings).

A plurality of layers of a composition in accordance with the present invention may be applied to a substrate surface; the plurality of layers may be simultaneously cured (by exposure to a single dose of radiation, for example) or each layer may be successively cured before application of an additional layer of the composition.

The curable compositions described herein are especially useful as 3D printing resin formulations, that is, compositions intended for use in manufacturing three-dimensional articles using 3D printing techniques. Such three-dimensional articles may be freestanding/self-supporting and may consist essentially of or consist of a curable composition that has been cured. The three-dimensional article may also be a composite, comprising at least one component consisting essentially of or consisting of a cured composition as previously mentioned as well as at least one additional component comprised of one or more materials other than such a cured composition (for example, a metal component or a thermoplastic component).

A method of making a three-dimensional article using a curable composition in accordance with the present invention may comprise the steps of :
a) coating a first layer of a curable composition in accordance with the present invention onto a surface ;
b) curing the first layer to provide a cured first layer ;
c) coating a second layer of the curable composition onto the cured first layer ;
d) curing the second layer to provide a cured second layer adhered to the cured first layer; and
e) repeating steps c) and d) a desired number of times to build up the three-dimensional article.

Although the curing steps may be carried out by any suitable means, which will in some cases be dependent upon the components present in the curable composition, in certain embodiments of the invention the curing is accomplished by exposing the layer to be cured to an effective amount of radiation (e.g., electron beam radiation, UV radiation, visible light, etc.).

Accordingly, in various embodiments, the present invention provides a process comprising the steps of :
a) coating a first layer of a curable composition in accordance with the present invention and in liquid form onto a surface ;
b) exposing the first layer imagewise to actinic radiation to form a first exposed imaged cross-section, wherein the radiation is of sufficient intensity and duration to cause at least partial curing (e.g., at least 80% or at least 90% curing) of the layer in the exposed areas ;
c) coating an additional layer of the curable composition onto the previously exposed imaged cross-section ;
d) exposing the additional layer imagewise to actinic radiation to form an additional imaged cross-section, wherein the radiation is of sufficient intensity and duration to cause at least partial curing (e.g., at least 80% or at least 90% curing) of the additional layer in the exposed areas and to cause adhesion of the additional layer to the previously exposed imaged cross-section ;
e) repeating steps c) and d) a desired number of times to build up the three-dimensional article.

According to one aspect of the invention, the block copolymer is a triblock copolymer of general structure A-B-A wherein the end A blocks have relatively high glass transition temperatures (e.g., ≥ 50°C) and the center B block has a relatively low glass transition temperature (e.g., ≤ 0°C), the hydrophilic or hydrophobic reactive component has a higher affinity for the end A blocks than for the center B block and when polymerized yields a polymer having a relatively high glass transition temperature (e.g., ≥ 50°C) and the other reactive component has a higher affinity for the center B block than for the end A blocks and when polymerized yields a polymer having a relatively low glass transition temperature (e.g., ≤ 0°C). Such curable compositions are expected to be useful for the production of reinforced rigid 3D printed products, structural adhesives and impact resistant films, for example.

According to another aspect of the invention, the block copolymer is a triblock copolymer of general structure A-B-A wherein the end A blocks have relatively low glass transition temperatures (e.g., ≤ 0°C) and the center B block has a relatively high glass transition temperature (e.g., ≥ 50°C), the hydrophilic or hydrophobic reactive component has a higher affinity for the end A blocks than for the center B block and when polymerized yields a polymer having a relatively low glass transition temperature (e.g., ≤ 0°C) and the other reactive component has a higher affinity for the center B block than for the end A blocks and when polymerized yields a polymer having a relatively high glass transition temperature (e.g., ≥ 50°C). Such curable compositions are expected to be useful for the production of reinforced elastomeric 3D printed products or packaging adhesives, for example.

In a further embodiment of the invention, the cured composition comprises hydrophobic phases or domains, as a result of using a reactive component comprised of one or more hydrophilic monomers, wherein the hydrophilic phases or domains are capable of absorbing and retaining water thereby acting as a sacrificial material.

According to other aspects, the microphase-separated structure achieved by curing the curable compositions of the invention may augment the breakage of the cured composition, thereby providing a more tear resistant material.

In yet other embodiments, the components of the curable composition may be selected to provide a hydrophilic phase in the cured composition which functions as a carrier for a ceramic, such as a ceramic dispersion which has been combined with the curable composition.

The cured composition may also be subjected to further processing after curing so as to alter the characteristics of the cured composition. For example, if the cured composition contains both a hydrophobic phase and a hydrophobic phase, a coating comprised of the cured composition may be formed on a substrate surface and then subjected to an etching process whereby at least a portion of the hydrophilic phase is selectively removed, leaving behind the hydrophobic phase. The etching thus may alter the surface texture and feel of the coating, thereby potentially creating a "soft touch" coating having more favorable or desirable haptic qualities.

### Exemplary Aspects of the Invention

Various non-limiting aspects of the present invention may be summarized as follows :
Aspect 1 : A curable composition, wherein the curable composition exists in an ordered microphase-separated state at 25°C and is comprised of, consists essentially of or consists of :
   a) a block copolymer comprised of at least a first block and a second block, wherein the first block and the second block have different monomer compositions ;
   b) a first reactive component having a higher affinity for the first block of the block copolymer than for the second block of the block copolymer ;
   c) a second reactive component having a higher affinity for the second block of block copolymer than for the first block of the block copolymer ;
   wherein the first reactive component and the second reactive component, in the absence of the block copolymer, are not fully miscible with each other at 25°C.
Aspect 2 : The curable composition of Aspect 1, wherein the first reactive component is comprised of one or more hydrophilic monomers and the second reactive component is comprised of one or more hydrophobic monomers.
Aspect 3 : The curable composition of Aspect 1 or 2, wherein the first reactive component is comprised of, consists essentially of or consists of at least one hydrophilic monomer selected from the group consisting of hydrophilic epoxides, hydrophilic oxetanes, hydrophilic vinyl compounds, hydrophilic acrylamides and hydrophilic (meth)acrylate-functionalized compounds.
Aspect 4 : The curable composition of any of Aspects 1 to 3, wherein the first reactive component is comprised of, consists essentially of or consists of at least one hydrophilic monomer selected from the group consisting of hydrophilic (meth)acrylate-functionalized compounds.
Aspect 5 : The curable composition of any of Aspects 1 to 4, wherein the first reactive component is comprised of, consists essentially of or consists of at least one hydrophilic monomer selected from the group consisting of acetoxyethyl (meth)acrylates, 2-carboxyethyl (meth)acrylates, phosphate (meth)acrylate monomers, mono-(2-(meth)acryloyloxyethyl) succinates, lactone (meth)acrylates, lactam (meth)acrylates, (meth)acrylamides, N,N-dimethyl(meth)acrylamide, N-isopropyl(meth)acrylamide, (meth)acryloyl morpholine, N-vinylformamide, polyethylene glycol (meth)acrylates and diacetone (meth)acrylamides.
Aspect 6 : The curable composition of Aspect 4, wherein the at least one hydrophilic monomer comprises, consists essentially of or consists of a half ester which is a reaction product of a hydroxyalkyl (meth)acrylate or an alkoxylated hydroxyalkyl (meth)acrylate and a dicarboxylic acid or carboxylic acid anhydride.
Aspect 7 : The curable composition of Aspect 6, wherein the hydroxyalkyl (meth)acrylate is selected from the group consisting of hydroxyethyl (meth)acrylates and hydroxypropyl (meth)acrylates.
Aspect 8 : The curable composition of Aspect 6 or 7, wherein the dicarboxylic acid or carboxylic acid anhydride is selected from the group consisting of succinic acid, succinic anhydride, malonic acid, methylsuccinic acid, and methylsuccinic anhydride.
Aspect 9 : The curable composition of Aspect 6, wherein the at least one hydrophilic monomer comprises, consists essentially of or consists of a half ester which is a reaction product of hydroxyethyl acrylate and succinic acid.
Aspect 10 : The curable composition of any of Aspects 1 to 9, wherein the second reactive component comprises, consists essentially of or consists of at least one (meth)acrylate ester of a C₄-C₂₄ aliphatic mono-alcohol.
Aspect 11 : The curable composition of any of Aspects 1 to 10, wherein the second reactive component comprises, consists essentially of or consists of at least one C₄-C₂₄ alkyl acrylate.
Aspect 12 : The curable composition of any of Aspects 1 to 10, wherein the second reactive component comprises, consists essentially of or consists of at least one hydrophobic reactive compound selected from the group consisting of aromatic (meth)acrylates, cycloaliphatic (meth)acrylates, vinyl aromatic compounds, vinyl cycloaliphatic compounds, C₆-C₂₄ olefins and (meth)acrylamides comprising a C₆-C₂₄ alkyl group.
Aspect 13 : The curable composition of any of Aspects 1 to 12, wherein the block copolymer comprises, consists essentially of or consists of at least one of a diblock copolymer or a triblock copolymer.
Aspect 14 : The curable composition of any of Aspects 1 to 13, wherein the block copolymer comprises at least one block having a glass transition temperature of at least 25°C and at least one block having a glass transition temperature of less than 25°C.
Aspect 15 : The curable composition of any of Aspects 1 to 14, wherein the block copolymer comprises at least one block having a glass transition temperature of at least 50°C and at least one block having a glass transition temperature of less than -25°C.
Aspect 16 : The curable composition of any of Aspects 1 to 15, wherein the block copolymer is a block copolymer selected from the group consisting of a) block copolymers comprised of at least one poly(n-butyl acrylate) block and at least one poly(methyl methacrylate) block, b) block copolymers comprised of at least one polystyrene block and at least one polybutadiene block and c) block copolymers comprised of at least one polystyrene block and at least one polyisoprene block.
Aspect 17 : The curable composition of any of Aspects 1 to 16, wherein the at least one block copolymer has a number average molecular weight of from 3,000 to 200,000 Daltons.
Aspect 18 : The curable composition of any of Aspects 1 to 17, wherein the curable composition is comprised of from 1 to 40% by weight block copolymer based on the total weight of the curable composition.
Aspect 19 : The curable composition of any of Aspects 1 to 18, additionally comprising at least one photoinitiator.
Aspect 20 : The curable composition of any of Aspects 1 to 19, additionally comprising inorganic nanoparticles.
Aspect 21 : The curable composition of Aspect 20, wherein the inorganic nanoparticles are dispersed in one or both of the first reactive component or the second reactive component.
Aspect 22 : The curable composition of Aspect 20 or 21, wherein the inorganic nanoparticles are selected from the group consisting of silica nanoparticles, alumina nanoparticles, iron oxide nanoparticles, niobia nanoparticles, titania nanoparticles, mixed oxide nanoparticles, intermetallic nanoparticles, zirconia nanoparticles, metal nanoparticles, clay nanoparticles and combinations thereof.
Aspect 23 : The curable composition of any of Aspects 1 to 22, comprising from 10 to 90% by weight first reactive component and from 90 to 10% by weight second reactive component based on the total weight of first reactive component and second reactive component.
Aspect 24 : A method, comprising curing the curable composition of any of Aspects 1 to 23.
Aspect 25 : A cured composition obtained by curing the curable composition of any of Aspects 1 to 23.
Aspect 26 : Use of the curable composition of any of Aspects 1 to 23 as an ink, a molding resin, a 3D printing resin, a coating or an adhesive.
Aspect 27 : A cured composition, comprising a first set of one or more polymeric domains comprised of a first reactive component in polymerized form, a second set of one of more polymeric domains comprised of a second reactive component in polymerized form, and a block copolymer comprised of at least one block associated with the first set of polymeric domains and at least one block associated with the second set of polymeric domains, wherein the first reactive component and the second reactive component, in the absence of the block copolymer, are not fully miscible with each other at 25°C.
Aspect 28 : A 3D article, which results from the curing of a curable composition of any one of aspects 1 to 23.
Aspect 29 : The 3D article of claim 28, which is a 3D printed article.

Within this specification, embodiments have been described in a way which enables a clear and concise specification to be written, but it is intended and will be appreciated that embodiments may be variously combined or separated without departing from the invention. For example, it will be appreciated that all preferred features described herein are applicable to all aspects of the invention described herein.

In some embodiments, the invention herein can be construed as excluding any element or process step that does not materially affect the basic and novel characteristics of the curable composition or process using the curable composition. Additionally, in some embodiments, the invention can be construed as excluding any element or process step not specified herein.

### Examples

Figures 1-3 illustrate certain exemplary, non-limiting aspects of the present invention. Two representative reactive components are shown : polyethylene glycol monoacrylate containing six oxyethylene repeating units (abbreviated as "PEA6") and 4-tert-butylcyclohexyl (meth)acrylate (abbreviated as "Tbchma"). The PEA6 is considered to be a hydrophilic monomer, whereas the Tbchma is categorized as a hydrophobic monomer. The structures of these monomers are shown in the second column of Fig. 1. Equal parts by weight of PEA6 and Tbchma were placed in a test tube at ambient temperature. As shown in the photographs at the top of the fourth column in Fig. 1, the monomers exhibited clean phase separation shortly after being agitated/mixed (the meniscus between the two liquid phases is visible, although difficult to discern, in the photograph on the left, which was taken some time after mixing the monomers and allowing the phases to separate) ; the photograph on the right, which was taken immediately after vigorously agitating the mixture, shows a somewhat cloudy mixture as a consequence of the temporary "emulsification" of the two liquid phases.

The lower row of Fig. 1 illustrates the results observed when a block copolymer is combined with the PEA6 and Tbchma. In this case, the block copolymer is a d-block containing a block of polymethyl methacrylate ("PMMA") and a block of polybutylacrylate ("PBA"), designed as "NS-1". A schematic structure of the block copolymer is shown in the second column of Fig. 1 ; the block copolymer structure has been simplified in the ester functional groups are not shown and the number of repeating units in each block does not necessarily correspond to the number of repeating units in the actual NS-1 block copolymer used. The block shown as having groups pendant to the backbone of the polymer represents the PBA block, while the other block is the PMMA block. In the presence of the NS-1 block copolymer, the PEA6 and Tbchma are compatibilized, such that a single homogeneous liquid phase is observed upon mixing, as shown in the photograph at the bottom of the fourth column of Fig. 1.

The third column in Fig. 1 provides an illustrative depiction of what is believed to be taking place at the molecular level in the two different mixtures. Without the block copolymer, an upper phase which is enriched in PEA6 and a lower phase which is enriched in Tbchma are formed. In the presence of the block copolymer (as shown in the panel at the bottom of the third column), the Tbchma molecules tend to preferentially associate with the PBA block of the block copolymer, while the PEA6 molecules tend to preferentially associate with the PMMA block of the block copolymer; the presence of the block copolymer thus assists in preventing phase separation of the dissimilar monomers on a macroscale.

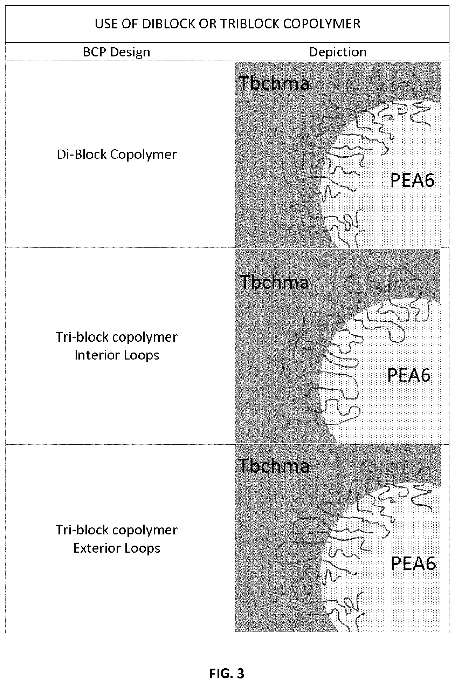

Fig. 3 illustrates different possible arrangements of a block copolymer relative to a Tbchma-rich domain and a PEA6-rich domain. In the first row of Fig. 3, molecules of a diblock copolymer (shown in schematic form as irregularly-curved lines) are shown wherein one block of the diblock copolymer has an affinity for the Tbchma-rich domain and the other block has an affinity for the PEA6-rich domain. In the second row of Fig. 3, molecules of a triblock (A-B-A) copolymer are shown wherein the center block has an affinity for the PEA6-rich domain while the two end blocks have an affinity for the Tbchma-rich domain, whereby the center B block forms an "interior loop" extending into the PEA6-rich domain. In the third row of Fig. 3, a triblock copolymer (B-A-B) is employed, whereby "exterior loops" extending into the Tbchma-rich domain are formed as a consequence of the center A block having a higher affinity for the Tbchma-rich domain and the end B blocks having a higher affinity for the PEA6-rich domain.

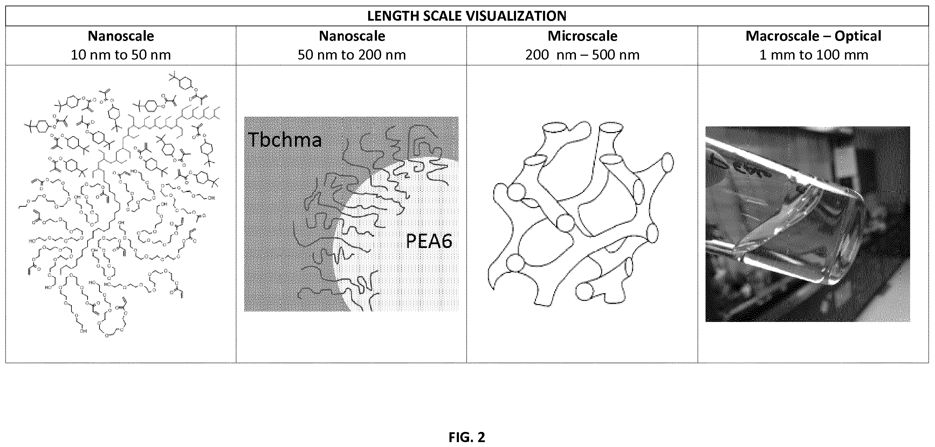

Fig. 2 contains further information regarding the embodiment illustrated in the bottom row of Fig. 1, in accordance with the present invention. In particular, the third column of Fig. 2 illustrates schematically a possible three-dimensional form of the domain formation occurring on a microscale (200 nm to 500 nm) when Tbcma and PEA6 monomers are combined in the presence of a suitable block copolymer. Fig. 2 shows an interconnected lattice formed by one of the monomers within a matrix of the other monomer. Other morphologies are possible as explained elsewhere in the present application, with the particular morphology being achieved being dependent upon variables such the relative amounts of the first and second reactive components, the types of monomers selected for use in the first and second reactive components, the type of block copolymer selected, as well as other factors.

## Claims

1. A curable composition, wherein the curable composition exists in an ordered microphase-separated state at 25°C and is comprised of :
a) a block copolymer comprised of at least a first block and a second block, wherein the first block and the second block have different monomer compositions ;
b) a first reactive component having a higher affinity for the first block of the block copolymer than for the second block of the block copolymer ;
c) a second reactive component having a higher affinity for the second block of block copolymer than for the first block of the block copolymer ;
wherein the first reactive component and the second reactive component, in the absence of the block copolymer, are not fully miscible with each other at 25°C.

2. The curable composition of claim 1, wherein the first reactive component is comprised of one or more hydrophilic monomers and the second reactive component is comprised of one or more hydrophobic monomers.

3. The curable composition of claim 1 or 2, wherein the first reactive component is comprised of at least one hydrophilic monomer selected from the group consisting of hydrophilic epoxides, hydrophilic oxetanes, hydrophilic vinyl compounds, hydrophilic acrylamides and hydrophilic (meth)acrylate-functionalized compounds.

4. The curable composition of any one of claims 1 to 3, wherein the first reactive component is comprised of at least one hydrophilic monomer selected from the group consisting of hydrophilic (meth)acrylate-functionalized compounds.

5. The curable composition of any one of claims 1 to 4, wherein the first reactive component is comprised of at least one hydrophilic monomer selected from the group consisting of acetoxyethyl (meth)acrylates, 2-carboxyethyl (meth)acrylates, phosphate (meth)acrylate monomers, mono-(2-(meth)acryloyloxyethyl) succinates, lactone (meth)acrylates, lactam (meth)acrylates, (meth)acrylamides, N,N-dimethyl(meth)acrylamides, N-isopropyl(meth)acrylamides, (meth)acryloyl morpholines, N-vinylformamide, polyethylene glycol mono(meth)acrylates and diacetone (meth)acrylamides.

6. The curable composition of claim 4, wherein the at least one hydrophilic monomer comprises a half ester which is a reaction product of a hydroxyalkyl (meth)acrylate or an alkoxylated hydroxyalkyl (meth)acrylate and a dicarboxylic acid or carboxylic acid anhydride.

7. The curable composition of any one of claims 1 to 6, wherein the second reactive component comprises at least one (meth)acrylate ester of a C₄-C₂₄ aliphatic mono-alcohol.

8. The curable composition of any one of claims 1 to 7, wherein the block copolymer comprises at least one block having a glass transition temperature of at least 25°C and at least one block having a glass transition temperature of less than 25°C.

9. The curable composition of any of claims 1 to 8, additionally comprising inorganic nanoparticles.

10. A method, comprising curing the curable composition of any of claims 1 to 9.

11. A cured composition obtained by curing the curable composition of any of claims 1 to 9.

12. Use of the curable composition of any of claims 1 to 9 as an ink, a molding resin, a 3D printing resin, a coating or an adhesive.

13. A cured composition, comprising a first set of one or more polymeric domains comprised of a first reactive component in polymerized form, a second set of one of more polymeric domains comprised of a second reactive component in polymerized form, and a block copolymer comprised of at least one block associated with the first set of polymeric domains and at least one block associated with the second set of polymeric domains, wherein the first reactive component and the second reactive component, in the absence of the block copolymer, are not fully miscible with each other at 25°C.

14. A 3D article, wherein it results from the curing of a curable composition of any one of claims 1 to 9.

15. The 3D article of claim 14, wherein it is a 3D printed article.

## Patentansprüche

1. Härtbare Zusammensetzung, wobei die härtbare Zusammensetzung bei 25 °C in einem geordneten mikrophasengetrennten Zustand vorliegt, bestehend aus:
a) einem Blockcopolymer bestehend aus wenigstens einem ersten Block und einem zweiten Block, wobei der erste Block und der zweite Block unterschiedliche Monomerzusammensetzungen aufweisen;
b) eine erste reaktionsfähige Komponente mit einer höheren Affinität für den ersten Block des Blockcopolymers als für den zweiten Block des Blockcopolymers;
c) eine zweite reaktionsfähige Komponente mit einer höheren Affinität für den zweiten Block des Blockcopolymers als für den ersten Block des Blockcopolymers;
wobei die erste reaktionsfähige Komponente und die zweite reaktionsfähige Komponente ohne Vorhandensein des Blockcopolymers bei 25 °C nicht vollständig miteinander mischbar sind.

2. Härtbare Zusammensetzung gemäß Anspruch 1, wobei die erste reaktionsfähige Komponente aus einem oder mehreren hydrophilen Monomeren besteht und die zweite reaktionsfähige Komponente aus einem oder mehreren hydrophoben Monomeren besteht.

3. Härtbare Zusammensetzung gemäß Anspruch 1 oder 2, wobei die erste reaktionsfähige Komponente aus wenigstens einem hydrophilen Monomer ausgewählt aus der Gruppe bestehend aus hydrophilen Epoxiden, hydrophilen Oxetanen, hydrophilen Vinylverbindungen, hydrophilen Acrylamiden und hydrophilen (Meth)acrylat-funktionalisierten Verbindungen besteht.

4. Härtbare Zusammensetzung gemäß einem der Ansprüche 1 bis 3, wobei die erste reaktionsfähige Komponente aus wenigstens einem hydrophilen Monomer ausgewählt aus der Gruppe bestehend aus hydrophilen (Meth)acrylat-funktionalisierten Verbindungen besteht.

5. Härtbare Zusammensetzung gemäß einem der Ansprüche 1 bis 4, wobei die erste reaktionsfähige Komponente aus wenigstens einem hydrophilen Monomer ausgewählt aus der Gruppe bestehend aus Acetoxyethyl(meth)acrylaten, 2-Carboxyethyl(meth)acrylaten, Phosphat(meth)acrylatmonomeren, Mono(2-(meth)acryloyloxyethyl) succinaten, Lacton(meth)acrylaten, Lactam(meth)acrylaten, (Meth)acrylamiden, N,N-Dimethyl(meth)acrylamiden, N-Isopropyl(meth)acrylamiden, (Meth)acryloylmorpholinen, N-Vinylformamid, Polyethylenglycolmono(meth)acrylaten und Diaceton(meth)acrylamiden besteht.

6. Härtbare Zusammensetzung gemäß Anspruch 4, wobei das wenigstens eine hydrophile Monomer einen Halbester umfasst, der ein Reaktionsprodukt eines Hydroxyalkyl(meth)acrylats oder eines alkoxylierten Hydroxyalkyl(meth)acrylats und einer Dicarbonsäure oder eines Carbonsäureanhydrids ist.

7. Härtbare Zusammensetzung gemäß einem der Ansprüche 1 bis 6, wobei die zweite reaktionsfähige Komponente wenigstens einen (Meth)acrylatester eines aliphatischen C₄-C₂₄-Monoalkohols umfasst.

8. Härtbare Zusammensetzung gemäß einem der Ansprüche 1 bis 7, wobei das Blockcopolymer wenigstens einen Block mit einer Glasübergangstemperatur von wenigstens 25 °C und wenigstens einen Block mit einer Glasübergangstemperatur von weniger als 25 °C umfasst.

9. Härtbare Zusammensetzung gemäß einem der Ansprüche 1 bis 8, zusätzlich umfassend anorganische Nanopartikel.

10. Verfahren, umfassend Härten der härtbaren Zusammensetzung gemäß einem der Ansprüche 1 bis 9.

11. Gehärtete Zusammensetzung, erhalten durch Härten der härtbaren Zusammensetzung gemäß einem der Ansprüche 1 bis 9.

12. Verwendung der härtbaren Zusammensetzung gemäß einem der Ansprüche 1 bis 9 als Tinte, Formharz, 3D-Druckharz, Beschichtung oder Klebstoff.

13. Gehärtete Zusammensetzung, umfassend einen ersten Satz von einer oder mehreren Polymerdomänen, die aus einer ersten reaktionsfähigen Komponente in polymerisierter Form bestehen, einen zweiten Satz von einer oder mehreren Polymerdomänen, die aus einer zweiten reaktionsfähigen Komponente in polymerisierter Form bestehen, und ein Blockcopolymer, das aus wenigstens einem Block, der mit dem ersten Satz von Polymerdomänen verbunden ist, und wenigstens einem Block, der mit dem zweiten Satz von Polymerdomänen verbunden ist, besteht, wobei die erste reaktionsfähige Komponente und die zweite reaktionsfähige Komponente ohne Vorhandensein des Blockcopolymers bei 25 °C nicht vollständig miteinander mischbar sind.

14. 3D-Gegenstand, erhalten durch Härten der härtbaren Zusammensetzung gemäß einem der Ansprüche 1 bis 9.

15. 3D-Gegenstand gemäß Anspruch 14, der ein 3D-gedruckter Gegenstand ist.

## Revendications

1. Composition durcissable, la composition durcissable existant dans un état ordonné à microphases séparées à 25 °C et étant composé de :
a) un copolymère à blocs comprenant au moins un premier bloc et un deuxième bloc, le premier bloc et le deuxième bloc ayant des compositions de monomères différentes ;
b) un premier composant réactif ayant une affinité plus élevée pour le premier bloc du copolymère à blocs que pour le deuxième bloc du copolymère à blocs ;
c) un deuxième composant réactif ayant une affinité plus élevée pour le deuxième bloc du copolymère à blocs que pour le premier bloc du copolymère à blocs ;
le premier composant réactif et le deuxième composant réactif, en l'absence du copolymère à blocs, n'étant pas totalement miscibles l'un avec l'autre à 25 °C.

2. Composition durcissable selon la revendication 1, le premier composant réactif étant composé d'un ou plusieurs monomères hydrophiles et le deuxième composant réactif étant composé d'un ou plusieurs monomères hydrophobes.

3. Composition durcissable selon la revendication 1 ou 2, le premier composant réactif étant composé d'au moins un monomère hydrophile choisi dans le groupe constitué par des époxydes hydrophiles, des oxétanes hydrophiles, des composés vinyliques hydrophiles, des acrylamides hydrophiles et des composés fonctionnalisés par (méth)acrylate hydrophiles.

4. Composition durcissable selon l'une quelconque des revendications 1 à 3, le premier composant réactif étant composé d'au moins un monomère hydrophile choisi dans le groupe constitué par des composés fonctionnalisés par (méth)acrylate hydrophiles.

5. Composition durcissable selon l'une quelconque des revendications 1 à 4, le premier composant réactif étant composé d'au moins un monomère hydrophile choisi dans le groupe constitué par des (méth)acrylates d'acétoxyéthyle, des (méth)acrylates de 2-carboxyéthyle, des monomères de (méth)acrylate de phosphate, des succinates de mono-(2-(méth)acryloyloxyéthyle), des (méth)acrylates de lactone, des (méth)acrylates de lactame, des (méth)acrylamides, des N,N-diméthyl(méth)acrylamides, des N-isopropyl(méth)acrylamides, des (méth)acryloylmorpholines, le N-vinylformamide, des mono(méth)acrylates de polyéthylène glycol et des diacétone (méth)acrylamides.

6. Composition durcissable selon la revendication 4, l'au moins un monomère hydrophile comprenant un semi-ester qui est un produit de réaction d'un (méth)acrylate d'hydroxyalkyle ou d'un (méth)acrylate d'hydroxyalkyle alcoxylé et d'un acide dicarboxylique ou d'un anhydride d'acide carboxylique.

7. Composition durcissable selon l'une quelconque des revendications 1 à 6, le deuxième composant réactif comprenant au moins un ester de (méth)acrylate d'un monoalcool aliphatique en C₄₋C₂₄.

8. Composition durcissable selon l'une quelconque des revendications 1 à 7, le copolymère à blocs comprenant au moins un bloc ayant une température de transition vitreuse d'au moins 25 °C et au moins un bloc ayant une température de transition vitreuse inférieure à 25 °C.

9. Composition durcissable selon l'une quelconque des revendications 1 à 8, comprenant de plus des nanoparticules inorganiques.

10. Procédé, comprenant le durcissement de la composition durcissable selon l'une quelconque des revendications 1 à 9.

11. Composition durcie obtenue par durcissement de la composition durcissable selon l'une quelconque des revendications 1 à 9.

12. Utilisation de la composition durcissable selon l'une quelconque des revendications 1 à 9 en tant qu'une encre, une résine de moulage, une résine d'impression 3D, un revêtement ou un adhésif.

13. Composition durcie, comprenant un premier ensemble d'un ou plusieurs domaines polymériques composés d'un premier composant réactif sous forme polymérisée, un deuxième ensemble d'un ou plusieurs domaines polymériques composés d'un deuxième composant réactif sous forme polymérisée, et un copolymère à blocs composé d'au moins un bloc associé au premier ensemble de domaines polymériques et au moins un bloc associé au deuxième ensemble de domaines polymériques, le premier composant réactif et le deuxième composant réactif, en l'absence du copolymère à blocs, n'étant pas totalement miscibles l'un à l'autre à 25 °C.

14. Article en 3D, qui résulte du durcissement d'une composition durcissable selon l'une quelconque des revendications 1 à 9.

15. Article en 3D selon la revendication 14, qui est un article imprimé en 3D.
